# FASCICULE DE BREVET EUROPEEN

(11) **EP 1 304 912 B1**
(45) Date de publication et mention de la délivrance du brevet: **16.04.2008**
(21) Numéro de dépôt: 02292333.8
(22) Date de dépôt: 23.09.2002
(51) Int. Cl.: H05K 7/02

(54) **Dispositif de maintien d'au moins deux composants électroniques disposés en vis-à-vis de part et d'autre d'une carte de connexion**
Haltevorrichtung mit mindestens zwei elektronischen Bauteilen auf gegenüberliegenden Seiten einer Schaltplatine aufgebracht
Holding device for at least two electronic components placed on opposite sides of a circuit board

(30) Priorité: 17.10.2001 FR 0113391
(43) Date de publication de la demande: 23.04.2003
(73) Titulaire: BULL S.A., 78430 Louveciennes (FR)
(72) Inventeur: Petit, Claude, 91140 Villebon-sur-Yvette (FR); Fromont, Thierry, 91300 Massy (FR); Prevot, Jean-Paul, 78330 Fontenay-le-Fleury (FR)
(74) Mandataire: Pellegrini, Marie Claude

(56) Documents cités:
- US-A- 3 459 998
- US-A- 6 157 539
- US-B1- 6 206 705

## Description

L'invention concerne un dispositif de maintien par pression d'au moins deux composants électroniques disposés en vis-à-vis et de part et d'autre d'une même carte de connexion.

Plus précisément, l'invention concerne un dispositif comportant
- deux plaques rigides d'appui disposées de part et d'autre de la carte de connexion, lesdites plaques étant destinées à exercer une force de maintien par pression sur lesdits composants électroniques en direction de la carte de connexion, et
- des premiers moyens de fixation de ces plaques d'appui à la carte de connexion comprenant au moins une colonnette de serrage et
- des moyens de sollicitation aptes à être montés à l'extrémité de ladite au moins une colonnette de serrage, ces moyens de sollicitation étant destinés à exercer sur une des plaques d'appui une force de poussée en direction de la carte de connexion,

Ces dispositifs de maintien par pression s'appliquent tout particulièrement à des composants électroniques dont le raccordement à une carte de connexion se fait par l'intermédiaire de bornes de contact. Ces bornes de contact sont aptes à coopérer avec des bornes de contact correspondantes situées sur la carte pour établir la continuité électrique. La continuité électrique entre les bornes de contact du composant électronique et de la carte est obtenue par une simple pression mécanique exercée sur le composant électronique en direction du circuit imprimé.

Un composant électronique pourvu d'une pluralité de bornes de contact constituant une matrice de contact plat LGA (Land Grid Array) est tout à fait adapté à la mise en oeuvre de ces dispositifs et, de ce fait, servira d'exemple dans la suite de cette description.

Les cartes de connexion peuvent être tous types de cartes destinées à recevoir des composants électriques ou électroniques tels que des cartes de circuit imprimé. Les cartes de circuit imprimé étant particulièrement fréquentes, elles serviront donc d'exemple dans la suite de la description pour illustrer un mode de réalisation de l'invention.

Traditionnellement, un composant électronique tel qu'un circuit intégré est mis dans un boîtier comprenant des bornes de contact. Dans la suite de la description, on utilisera l'expression "circuit intégré LGA" pour désigner aussi bien un circuit intégré LGA qu'un circuit placé dans un boîtier.

Traditionnellement, le circuit intégré LGA comporte deux faces, l'une active et l'autre inactive. La face active comporte les bornes de contact.

Généralement, la connexion d'un circuit intégré LGA sur une première face d'une carte de circuit imprimé nécessite l'utilisation d'une première plaque d'appui pour exercer une pression sur la face inactive du circuit intégré LGA et des premiers moyens de fixation de cette plaque à la carte de circuit imprimé. Les premiers moyens de fixation comportent des colonnettes destinées à être fixées à la carte de circuit imprimé à l'aide d'inserts ou d'écrous pratiqués dans celle-ci.

Le montage d'un second circuit intégré LGA sur la seconde face de circuit imprimé, opposée à la première, nécessite également une seconde plaque d'appui et des seconds moyens de fixation identiques respectivement à la première plaque d'appui et aux premiers moyens de fixation. Les seconds moyens de fixation sont également fixés à la carte de circuit imprimé à l'aide d'inserts ou d'écrous pratiqués dans celle-ci.

L'inconvénient soulevé par cette technique est qu'il n'est pas possible de placer, sur chaque côté de la carte de circuit imprimé et en vis-à-vis, les inserts ou écrous de fixation nécessaires pour les premiers moyens de fixation et ceux nécessaires pour les seconds moyens de fixation. Ainsi, il n'est pas possible, avec les dispositifs de maintien de composants électroniques connus, de maintenir par pression des composants électroniques disposés en vis-à-vis sur chaque face de la même carte de circuit imprimé.

L'invention vise à remédier à cet inconvénient en proposant un dispositif de maintien par pression de deux composants électroniques disposés en vis-à-vis chacun sur une face opposée d'une même carte de circuit imprimé.

L'invention a donc pour objet un dispositif de maintien par pression tel que décrit plus haut, caractérisé en ce que des ouvertures étant ménagées dans la carte de connexion, ladite au moins une colonnette de serrage est apte à être montée déplaçable en translation dans une desdites ouvertures pour traverser la carte de connexion et à recevoir, à chacune de ses extrémités, les moyens de sollicitation, et en ce qu'il comporte deux butées de fixation pour limiter la translation de ladite au moins une colonnette de serrage à travers la carte de connexion, lesdites butées de fixation étant destinées à être disposées chacune de part et d'autre de la carte de connexion, espacées l'une de l'autre d'une distance strictement supérieure à l'épaisseur de la carte de manière à ménager entre la carte et les butées un jeu d'équilibrage de la force de maintien entre les deux plaques d'appui.

Le dispositif décrit ci-dessus permet de maintenir par pression au moins deux composants électroniques disposés en vis-à-vis chacun sur une face respective d'une même carte de circuit imprimé. En effet, dans ce dispositif, les première et seconde plaques d'appui pour maintenir par pression les composants électroniques, sont fixées l'une à l'autre par l'intermédiaire de colonnettes de serrage traversant de part en part la carte de circuit imprimé. Ces plaques ne sont donc plus fixées par l'intermédiaire de moyens de fixation respectifs à la carte de circuit imprimé et ainsi, il n'est plus nécessaire de réaliser dans cette carte des inserts ou des écrous.

Suivant d'autres caractéristiques d'un dispositif de maintien par pression conforme à l'invention :
- ladite au moins une colonnette de serrage comporte deux organes d'accueil des butées de fixation espacés l'un de l'autre d'une distance strictement supérieure à l'épaisseur de la carte de manière à ménager entre la carte et les butées le jeu d'équilibrage de la force de maintien entre les deux plaques d'appui ;
- les butées comportent un anneau d'arrêt ;
- les butées comportent une rondelle ;
- les moyens de sollicitation comportent des supports de poussée destinés à être fixés à chaque extrémité de ladite au moins une colonnette de serrage et des moyens élastiques aptes à être interposés entre le support de poussée et l'une des plaques d'appui pour solliciter cette dernière contre les composants électroniques ;
- les moyens élastiques comportent des ressorts ;
- il comporte une plaque de blocage en rotation de ladite au moins une colonnette de serrage dans laquelle est formée une ouverture destinée à recevoir à coulissement ladite au moins une colonnette de serrage, le profil de l'ouverture, et celui de ladite au moins une colonnette de serrage étant réalisés de manière à empêcher tout mouvement de rotation de ladite au moins une colonnette de serrage par rapport aux plaques d'appui ;
- les premiers moyens de fixation sont uniquement aptes à fixer lesdites plaques d'appui à la carte de connexion ;
- il comporte des seconds moyens de fixation d'un radiateur de dissipation d'énergie thermique sur au moins l'une desdites plaques d'appui, ces seconds moyens de fixation étant indépendants et distincts des premiers moyens de fixation.
- les seconds moyens de fixation comportent un clip de torsion apte à venir en appui sur l'une des plaques d'appui) et sur le radiateur correspondant.

L'invention a également pour objet une carte électronique, caractérisée en ce qu'elle comporte un dispositif de maintien par pression d'au moins deux composants électroniques disposés en vis-à-vis et de part et d'autre d'une même carte de connexion, le dispositif de maintien étant conforme à l'invention.

L'invention sera mieux comprise à la lecture de la description qui va suivre, donnée uniquement à titre d'exemple et faite en se référant aux dessins sur lesquels :
- la figure 1 est une vue éclatée et en perspective des différents éléments d'un dispositif de maintien par pression conforme à l'invention, et
- la figure 2 est un organigramme d'un procédé de montage d'un dispositif de maintien par pression conforme à l'invention.

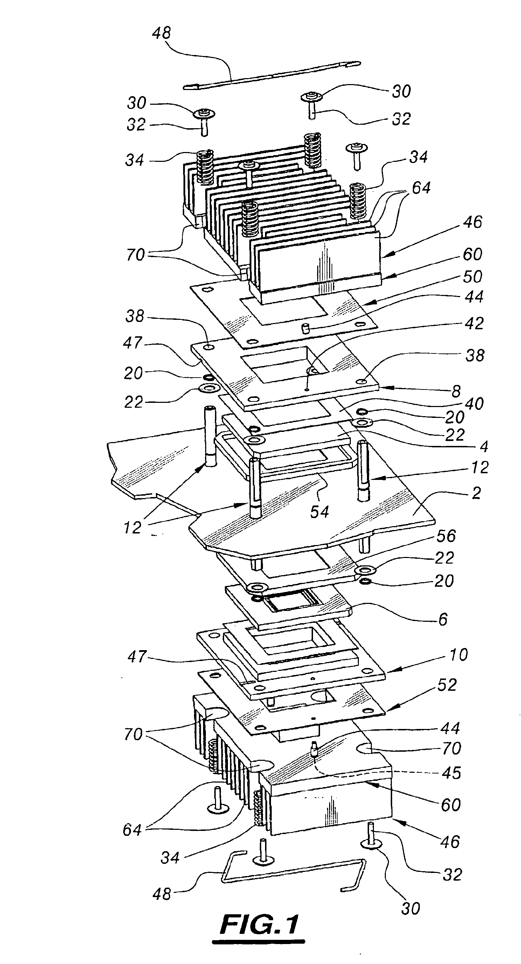

Sur la figure 1, les pièces identiques ou similaires portent la même référence.

La figure 1 représente une carte 2 de circuit imprimé sur chaque face de laquelle un premier et un second circuits intégrés LGA 4, 6 sont destinés à être assemblés en vis-à-vis à l'aide d'un dispositif de maintien par pression.

Le dispositif de maintien par pression comporte des plaques d'appui 8, 10 disposées de part et d'autre de la carte 2 et destinées à être fixées l'une à l'autre à l'aide de premiers moyens de fixation.

Les premiers moyens de fixation comportent quatre colonnettes 12 de serrage (la quatrième colonnette n'est pas visible sur la figure 1) destinées à être montées à coulissement dans des trous formés dans la carte 2. Ces colonnettes de serrage ont une forme cylindrique avec un méplat réalisé dans le sens de la longueur à chaque extrémité. A chacune des extrémités de chaque colonnette, un perçage fileté destiné à recevoir des moyens de sollicitation est réalisé dans un plan perpendiculaire à l'axe longitudinal des colonnettes.

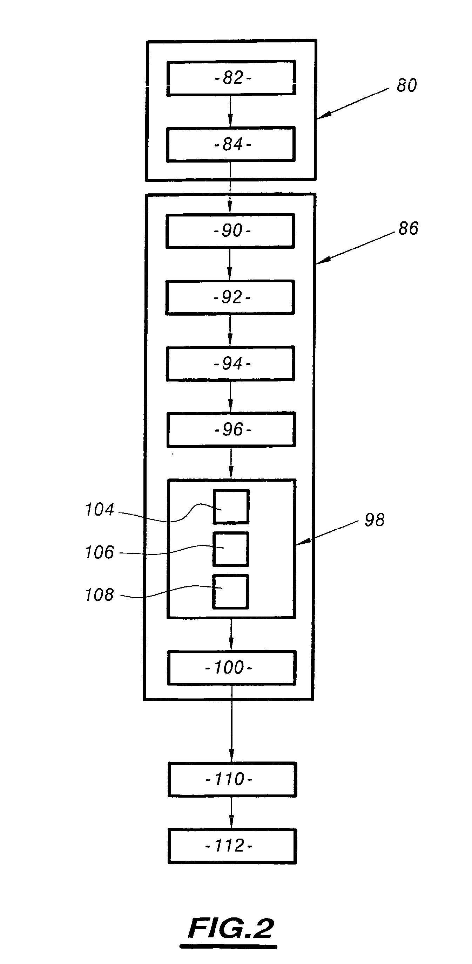

Les colonnettes comportent également de part et d'autre du milieu de leur longueur un organe d'accueil destiné à recevoir une butée de fixation. Cet organe d'accueil est ici une gorge entourant la colonnette 12. Ces gorges sont espacées d'une distance strictement supérieure à l'épaisseur de la carte de manière à ménager entre chaque butée de fixation et la carte 2 de circuit imprimé un jeu d'équilibrage. Cet espacement entre les deux butées de fixation est également choisi de manière à permettre l'exercice d'une force de maintien minimale sur l'un des circuits intégrés LGA 4, 6 lors du montage du dispositif de maintien. Une description de la force de maintien minimale sera donnée en regard de la figure 2. Pour cela, le jeu d'équilibrage ne doit pas être trop important. Par exemple, les gorges sont espacées l'une de l'autre de 5 mm lorsque l'épaisseur de la carte 2 est d'environ 1,5 mm.

Les butées de fixation, destinées à être montées deux par deux sur chaque colonnette de serrage, sont formées ici par un anneau d'arrêt 20 et une rondelle 22. L'anneau d'arrêt est par exemple un circlip adapté pour être introduit dans les gorges réalisées sur les colonnettes de serrage. La rondelle 22 a un diamètre extérieur supérieur à celui des trous de la carte 2 et une ouverture centrale suffisamment grande pour recevoir à coulissement les colonnettes de serrage 12.

Les moyens de sollicitation, destinés à être montés à chaque extrémité des colonnettes de serrage, sont aptes à exercer sur la plaque d'appui correspondante une force de poussée en direction de la carte 2. Pour cela, ils comportent un support de poussée et des moyens élastiques. Le support de poussée est ici réalisé à l'aide d'une rondelle 30 et d'une vis 32. La rondelle 30 est propre à être introduite à coulissement à l'extrémité des colonnettes de serrage 12. La vis est apte à être montée dans le perçage fileté situé à l'extrémité des colonnettes de serrage. La tête de la vis 32 est suffisamment large pour bloquer en translation la rondelle 30 lorsque celle-ci se déplace le long d'une des colonnettes.

Les moyens élastiques des moyens de sollicitation sont formés par un ressort hélicoïdal 34 apte à être monté à coulissement à l'extrémité des colonnettes de serrage et destiné à être interposé entre le support de poussée et la plaque d'appui correspondante.

Les plaques d'appui 8 et 10 sont identiques et seule la plaque d'appui 8 sera décrite ici. Cette plaque d'appui 8 est une plaque rectangulaire en aluminium dans laquelle est ménagée une ouverture rectangulaire centrale. Elle comporte quatre trous circulaires 38 disposés à proximité de chaque angle de la plaque et destinés à recevoir à coulissement les colonnettes de serrage 12. La face inférieure de la plaque 8, c'est-à-dire la face tournée vers la carte 2, est destinée à recevoir une fine plaque d'isolation électrique 40. Dans cette plaque d'isolation électrique 40, une ouverture rectangulaire de mêmes dimensions que celles de la plaque 8 est ménagée. Deux trous 42 traversent de part en part la plaque 8 (seul un des ces trous est visible sur la figure 1). Ces trous 42 sont destinés à recevoir chacun une pion de positionnement 44 d'un radiateur 46. Les pions de positionnement 44 sont formées de deux parties cylindriques de diamètres différents. La partie de plus petit diamètre est apte à être insérée dans le trou 42 tandis que la partie de plus grand diamètre est propre à être insérée dans un trou 45 correspondant ménagé dans le radiateur 46. Deux encoches 47 de réception d'un clip de torsion 48 sont également creusées dans la tranche de la plaque 8,

Le dispositif de maintien par pression comporte également deux plaques 50, 52 de blocage en rotation des colonnettes de serrage 12 et deux interposeurs 54, 56. Les plaquettes de blocage 50, 52 sont destinées à être placées sur la face supérieure des plaques d'appui. Elles sont réalisées par découpage d'un rectangle de mêmes dimensions que la plaque d'appui 8 dans une feuille d'acier de 5/10 d'épaisseur. Elles comportent chacune deux trous de passage des pions de positionnement 44. Une ouverture rectangulaire centrale dont les dimensions sont les mêmes que celles de l'ouverture centrale de la plaque 8 et quatre trous sont ménagés dans les plaques de blocage 50 et 52. Cette ouverture centrale et ces trous sont réalisés de manière à s'aligner avec respectivement l'ouverture centrale et les quatre trous d'une plaque d'appui. Chacun des trous des plaques de blocage 50 et 52 est destiné à recevoir à coulissement une des colonnettes de serrage 12 tout en empêchant sa rotation. Pour cela, le profil de chacun de ces trous s'adapte exactement à celui des colonnettes de serrage. Ainsi, ce profil comporte notamment une portion rectiligne apte à coopérer avec le méplat de chacune des colonnettes de serrage pour empêcher la rotation de celle-ci.

Chacun des interposeurs 54, 56 est destiné à être disposé entre un des circuits intégrés LGA 4, 6 et la carte 2. Ces interposeurs comprennent des contacts électriques souples propres à établir la continuité électrique entre les bornes de contact du circuit intégré LGA et des bornes de contact correspondantes de la carte 2.

Finalement, le dispositif de maintien par pression représenté sur la figure 1 comporte également des seconds moyens de fixation d'un radiateur aux plaques d'appui. Ces seconds moyens de fixation sont par exemple réalisés à l'aide du clip de torsion 48.

La figure 1 comporte également deux radiateurs identiques de dissipation thermique 46. Chaque radiateur 46 comporte une plaque 60 dont la surface inférieure est destinée à être placée sur l'une des plaques de blocage 50, 52. Cette surface inférieure de la plaque 60, tournée vers la carte 2, comporte en son centre un parallélépipède saillant adapté pour être introduit à coulissement à l'intérieur des ouvertures centrales de la plaque de blocage, de la plaque d'appui et de l'isolant électrique. La surface de ce parallélépipède destinée à venir en contact avec l'un des circuits intégrés LGA 4, 6 est équipée d'un joint thermique (non représenté) pour améliorer les échanges de chaleur avec le circuit intégré LGA.

La partie supérieure de la plaque 60 comporte des ailettes de ventilation 64 disposées perpendiculairement à la surface de la plaque 60 et parallèles les unes aux autres. Ces ailettes sont propres à améliorer les échanges thermiques entre le milieu ambiant et le radiateur 46. Cette surface supérieure de la plaque 60 est également adaptée pour recevoir une portion d'appui du clip de torsion 48.

Des encoches 70 sont réalisées dans la tranche de la plaque 60 pour recevoir les premiers moyens de fixation du dispositif de maintien par pression. Ces encoches sont suffisamment vastes pour recevoir sans contact les ressorts 34 des moyens de sollicitation.

Le montage du dispositif de maintien par pression de la figure 1 va maintenant être décrit en regard de la figure 2.

Le procédé de montage de la figure 2 comporte une étape 80 de fixation des colonnettes de serrage 12 à la carte 2 de circuit imprimé. Cette étape 80 comporte deux opérations principales 82 et 84 réalisées pour chacune des colonnettes de serrage. L'opération 82 consiste à introduire à coulissement une colonnette de serrage 12 dans un des trous de la carte 2 de circuit imprimé prévu à cet effet. La colonnette de serrage 12 est logée dans le trou de la carte 2 de manière à ce que les butées de fixation de celle-ci puissent être montées de part et d'autre de la carte 2.

L'opération 84 consiste à fixer la colonnette de serrage 12 placée à travers la carte 2 lors de l'opération précédente à l'aide de butées de fixation. Ces butées de fixation étant réalisées ici à l'aide de l'anneau d'arrêt 20 et de la rondelle 22, cette opération 84 consiste à introduire à coulissement la rondelle 22 autour de la colonnette de serrage puis à introduire l'anneau d'arrêt 20 dans la gorge de la colonnette de serrage 12 prévue à cet effet de manière à maintenir la rondelle 22 logée entre la carte 2 et l'anneau d'arrêt 20. Les butées de fixation de chaque colonnette sont montées de part et d'autre de la carte 2. A l'issue de cette étape 80, l'espacement des deux butées de fixation de chaque colonnette permet le déplacement en translation de ces dernières dans les trous correspondant de la carte 2 entre deux positions extrêmes dans lesquelles l'une des butées de fixation est en appui sur l'une des faces de la carte 2. La course en translation de chaque colonnette entre ces deux positions extrêmes est définie par le jeu d'équilibrage. A ce stade là du montage, les colonnettes sont libres en rotation.

Lorsque les colonnettes de serrage 12 ont été montées, une étape 86 de maintien par pression du premier circuit intégré LGA 4 débute. Cette étape 86 comporte sept sous-étapes 90, 92, 94, 96, 98, 100 et 102 successives.

Lors de ces sous-étapes, la carte 2 est maintenue à l'horizontale et les différents éléments assemblés sur celle-ci le sont du côté de la carte orientée vers le haut. Ainsi, ces différents éléments sont maintenus sur la carte 2 par gravité.

La sous-étape 90 consiste à placer l'interposeur 54 en contact avec les bornes de contact de la carte 2 et ensuite à placer le circuit intégré LGA 4 dans l'interposeur 54 de manière à ce que les bornes de contact du circuit intégré 4 soient raccordées électriquement à celles de la carte 2 lorsqu'une pression est exercée sur la face inactive du circuit intégré LGA 4.

La sous-étape 92 consiste à introduire à coulissement la plaque d'appui 8 pré-équipée de l'isolant électrique 40 sur les colonnettes de serrage 12 fixées à la carte lors de l'étape 80. Pour cela, chacune des colonnettes de serrage 12 est introduite dans les trous disposés aux quatre angles de la plaque d'appui 8. A l'issue de cette sous-étape, l'isolant électrique 40 disposé sur la face inférieure de la plaque d'appui 8 est en contact avec la face inactive du circuit intégré LGA 4.

Lors de la sous-étape 94, la plaque 50 de blocage en rotation est placée sur la surface supérieure de la plaque d'appui 8. A cet effet, chaque colonnette de serrage 12 est introduite à coulissement dans le trou correspondant de la plaque 50. Le méplat de chaque colonnette de serrage 12 coopère alors avec la partie rectiligne des trous réalisés dans la plaque 50 pour assurer un blocage en rotation des colonnettes de serrage 12.

Ensuite, lors de la sous-étape 96, le cylindre de plus petit diamètre des pions de positionnement 44 est enfoncé, à travers la plaque 50, dans les trous 42 de la plaque d'appui 8.

La sous-étape 98 est une étape de montage des moyens de sollicitation aux extrémités des colonnettes de serrage situées vers le haut, pour exercer une force de poussée sur la plaque 8 en direction de la carte 2. Cette sous-étape consiste à réitérer trois opérations 104, 106 et 108 pour chacune des extrémités situées vers le haut. L'opération 104 consiste à introduire à coulissement un ressort 34 autour de l'extrémité de la colonnette de serrage. Une des extrémités du ressort 34 vient en appui sur la plaque 50. L'opération 106 consiste à disposer dans l'axe du ressort et sur son extrémité opposée à celle en contact avec la plaque 8, une des rondelles 30. Lors de l'opération 108, une des vis 32 est introduite dans l'ouverture centrale de la rondelle 30 et du ressort hélicoïdal 34 pour être vissée dans le perçage fileté ménagé à l'extrémité de la colonnette de serrage 12. Ainsi, la vis 32 et la rondelle 30 compriment le ressort 34 contre la plaque d'appui 8, le ressort 34 sollicitant alors la plaque d'appui 8 en direction de la carte 2 de circuit imprimé.

A l'issue de cette sous-étape 98, les quatre ressorts 34 montés sollicitent la plaque d'appui 8 contre la surface inactive du circuit intégré LGA. La plaque d'appui 8 exerce ainsi une force de maintien minimale sur la face inactive du circuit intégré LGA 4. Les ressorts 34 exercent également une force de réaction contre les rondelles 30 et les vis 32, ce qui tend à déplacer les colonnettes de serrage 12 vers le haut. Les colonnettes de serrage 12 exercent donc, sur la carte 2, par l'intermédiaire des butées de fixation situées du côté de la face tournée vers le bas de la carte 2, une force de serrage en direction de la plaque d'appui 8. Cette force de serrage est transmise par l'intermédiaire de la carte 2 à l'interposeur 54 et s'exerce donc sur la face active du circuit intégré LGA 4. Ainsi, l'interposeur 54 et le circuit intégré LGA 4 sont maintenus coincés par une force de maintien minimale entre d'une part la plaque d'appui 8 et d'autre part la carte 2 de circuit imprimé.

Lors de la sous-étape 100, le radiateur 46 est placé sur la plaque de blocage 50. Pour cela, la partie cylindrique de plus grand diamètre des pions de positionnement 44 est enfoncée dans les trous 45 correspondant de la plaque 60 du radiateur 46. Ensuite, lors de cette même étape, les seconds moyens de fixation, c'est-à-dire le clip de torsion 48 est monté dans les encoches prévues à cet effet de la plaque d'appui 8 et en appui sur les surfaces correspondantes du radiateur 46 pour exercer une force de maintien de celui-ci en contact thermique avec la plaque 50 de blocage en rotation. Les seconds moyens de fixation du radiateur étant indépendants des premiers moyens de fixation de la plaque d'appui 8 à la carte 2 de circuit imprimé, la force nécessaire pour réaliser un bon contact thermique est définie indépendamment de la force de maintien exercée sur le circuit intégré LGA 4.

L'étape 86 se poursuit par une étape 110 consistant à retourner la carte 2 pour présenter vers le haut la surface destinée à recevoir le circuit intégré LGA 6.

Après cette étape 110 de retournement, une étape 112 de maintien par pression du second circuit intégré LGA 6 est exécutée. Cette étape 112 est similaire à l'étape 86 et ne sera donc pas décrite en détail.

A l'issue de cette étape 112, la force de réaction exercée par les quatre ressorts 34 situés d'un premier côté de la carte 2, c'est-à-dire du côté de la plaque 8, sur les quatre supports de poussée situés du même côté, et non plus transmise à la carte 2 par l'intermédiaire des butées de fixation, mais transmise aux supports de poussées situés du second côté de la carte 2 par l'intermédiaire des colonnettes de serrage 12. Cette force de réaction, transmise aux supports de poussée situés du second côté, est égale, en amplitude, à la force de poussée exercée en sens inverse sur la plaque d'appui 10 par les ressorts 34 situés du second côté. Cette force de poussée exercée par les ressorts situés du second côté est égale à la force exercée par la plaque 10 sur la face inactive du circuit intégré LGA 6. Cette force de maintien exercée par la plaque d'appui 10 s'exerce également par l'intermédiaire de l'interposeur 56 sur la face de la carte 2 située du second côté. Par ailleurs, la force de réaction exercée par les ressorts 34 situés du premier côté est égale à la force de poussée qu'ils exercent sur la plaque d'appui 8. Cette force de poussée exercée par les ressorts situés du premier côté est égale à la force de maintien exercée par la plaque d'appui 8 sur la face inactive du circuit intégré LGA 4. Cette force de maintien exercée par la plaque d'appui 8 est également transmise à la face de la carte 2 située du premier côté par l'intermédiaire de l'interposeur 54. Ainsi, les forces exercées de chaque côté de la carte 2 étant égales, on obtient un équilibrage des forces de maintien exercées par les plaques d'appui 8 et 10. Dans ces conditions, les butées de fixation de chacune des colonnettes de serrage ne sont en appui sur aucune des faces de la carte 2 de circuit imprimé. Le dispositif de maintien par pression décrit ici permet d'équilibrer les forces de maintien exercées par chacune des plaques d'appui 8 et 10. Il n'est donc plus nécessaire de calibrer très précisément les ressorts 34 pour obtenir la même force de maintien sur chacun des circuits intégrés LGA.

Le dispositif de maintien par pression décrit ici permet également, grâce à la présence de butées de fixation sur les colonnettes de serrage, de monter et de démonter les premiers moyens de fixation sans l'aide d'outillages spéciaux. En effet, lorsqu'un seul des circuits intégrés LGA est monté, une force de maintien minimale de ce premier circuit intégré LGA est exercée sur celui-ci grâce aux butées de fixation des colonnettes de serrage. Ainsi, la carte 2 peut être retournée pour monter le second circuit intégré LGA puisque le premier circuit intégré LGA est maintenu par cette force de maintien minimale.

La surface nécessaire pour installer les premiers moyens de fixation sur la carte 2 est inférieure à celle nécessaire pour installer les moyens de fixation connus tels que les inserts et les écrous. Le dispositif de maintien décrit ici permet donc aussi d'accroître la surface utile de la carte 2 pour dessiner le circuit imprimé. En effet, le circuit imprimé est dessiné à l'aide de méthodes connues même sous les rondelles 22.

Finalement, les plaques de blocage 50, 52 réalisent à moindre coût l'immobilisation en rotation des colonnettes de serrage. En effet, le coût de réalisation d'un trou dont le profil comporte par exemple une portion linéaire est inférieur au coût de réalisation d'un trou ayant le même profil dans les plaques d'appui.

En variante, les colonnettes de serrage sont formées d'un premier et d'un second piliers de même longueur mis bout à bout. Chaque pilier comporte une première et une seconde extrémités. La première extrémité est apte à recevoir des moyens de sollicitation des plaques d'appui. Cette première extrémité est par exemple identique à celle des colonnettes de serrage 12 et comporte donc également un méplat. La seconde extrémité est destinée à coulisser dans les trous de la carte de circuit imprimé. Cette seconde extrémité comporte des moyens d'assemblage des premier et second piliers entre eux. Chaque pilier comporte également un bossage légèrement en retrait de la seconde extrémité, destiné à remplir les mêmes fonctions qu'une des butées de fixation précédemment décrites. Ces bossages sont donc suffisamment éloignés de la seconde extrémité pour ménager un jeu d'équilibrage entre la carte de circuit imprimé et le bossage.

Le procédé de montage de cette variante est similaire à celui décrit en regard de la figure 2, à l'exception de l'étape 80 de fixation des colonnettes de serrage. En effet, cette étape 80 ne comporte plus des opérations d'introduction à coulissement des colonnettes de serrage mais des opérations d'assemblage des premier et second piliers entre eux dans les trous de la carte de circuit imprimé. Une fois un premier et un second piliers assemblés entre eux, ceux-ci forment une colonnette de serrage montée déplaçable en translation dans les trous de la carte de circuit imprimé, ce déplacement en translation étant limité de part et d'autre de la carte de circuit imprimé par les bossages des piliers.

Une variante du procédé de montage de la figure 2 consiste à réaliser à l'avance l'assemblage de la plaque d'appui 8, de l'isolant électrique 40, de la plaque de blocage 50, et des deux pions 44 de manière à réaliser un ensemble pré-assemblé. Ainsi dans cette variante, les sous-étapes 92, 94 et 96 du procédé de la figure 2 sont remplacées par une seule sous-étape consistant à introduire à coulissement sur les colonnettes de serrage 12 cet ensemble pré-assemblé.

Le dispositif de maintien de composant électronique a été ici décrit dans le cas particulier où il comporte quatre colonnettes de serrage. Toutefois, des variantes avec une, deux ou trois colonnettes de serrage ou plus sont réalisables. Ainsi, par exemple, le dispositif de maintien comporte une seule colonnette de serrage lorsque deux paires de composants électroniques sont disposés en vis-à-vis et de part et d'autre de la carte de circuit imprimé. Dans cette variante, la colonnette traverse la carte de circuit imprimé entre les deux composants électroniques formant chaque paire de composants électroniques. Par ailleurs, le dispositif de maintien est adapté pour que, une fois montée, l'unique colonnette de serrage traverse les différents éléments du dispositif de maintien à proximité de leur centre de gravité respectif.

## Revendications

1. Dispositif de maintien par pression d'au moins deux composants électroniques (4, 6) disposés en vis-à-vis et de part et d'autre d'une même carte (2) de connexion, ledit dispositif comportant :
- deux plaques rigides d'appui (8, 10) disposées de part et d'autre de ia carte (2) de connexion, lesdites plaques étant destinées à exercer une force de maintien par pression sur lesdits composants électroniques (4, 6) en direction de la carte de connexion, et
- des premiers moyens de fixation de ces plaques d'appui à la carte (2) de connexion comprenant au moins une colonnette de serrage (12), et
- des moyens de sollicitation (30, 32, 34) aptes à être montés à l'extrémité de ladite au moins une colonnette de serrage, ces moyens de sollicitation étant destinés à exercer sur une des plaques d'appui (8, 10) une force de poussée en direction de la carte de connexion,
**caractérisé en ce que** des ouvertures étant ménagées dans la carte de connexion, ladite au moins une colonnette de serrage (12) est apte à être montée déplaçable en translation dans une desdites ouvertures pour traverser la carte (2) de connexion et à recevoir, à chacune de ses extrémités, les moyens de sollicitation (30, 32, 34), et **en ce que** dispositif comporte deux butées de fixation (20, 22) pour limiter la translation de ladite au moins une colonnette de serrage (12) à travers la carte de connexion, lesdites butées de fixation étant destinées à être disposées chacune de part et d'autre de la carte (2) de connexion, espacées l'une de l'autre d'une distance strictement supérieure à l'épaisseur de la carte de manière à ménager entre la carte et les butées un jeu d'équilibrage de la force de maintien entre les deux plaques d'appui.

2. Dispositif selon la revendication 1, **caractérisé en ce que** ladite au moins une colonnette de serrage (12) comporte deux organes d'accueil des butées de fixation (20, 22) espacés l'un de l'autre d'une distance strictement supérieure à l'épaisseur de la carte de manière à ménager entre la carte et les butées le jeu d'équilibrage de la force de maintien entre les deux plaques d'appui (8, 10).

3. Dispositif selon l'une quelconque des revendications précédentes, **caractérisé en ce que** les butées comportent un anneau d'arrêt (20).

4. Dispositif selon l'une quelconque des revendications précédentes, **caractérisé en ce que** les butées comportent une rondelle (22).

5. Dispositif selon l'une quelconque des revendications précédentes, **caractérisé en ce que** les moyens de sollicitation comportent des supports de poussée (30, 32) destinés à être fixés à chaque extrémité de ladite au moins une colonnette de serrage (12) et des moyens élastiques (34) aptes à être interposés entre le support de poussée (30, 32) et l'une des plaques d'appui (8, 10) pour solliciter cette dernière contre les composants électroniques (4, 6).

6. Dispositif selon la revendication 5, **caractérisé en ce que** les moyens élastiques comportent des ressorts (34).

7. Dispositif selon l'une quelconque des revendications précédentes, **caractérisé en ce qu**'il comporte une plaque (50, 52) de blocage en rotation de ladite au moins une colonnette de serrage (12) dans laquelle est formée une ouverture destinée à recevoir à coulissement ladite au moins une colonnette de serrage (12), le profil de l'ouverture, et celui de ladite au moins une colonnette de serrage (12) étant réalisés de manière à empêcher tout mouvement de rotation de ladite au moins une colonnette de serrage (12) par rapport aux plaques d'appui (8, 10).

8. Dispositif selon l'une quelconque des revendications précédentes, **caractérisé en ce que** les premiers moyens de fixation sont uniquement aptes à fixer lesdites plaques d'appui (8, 10) à la carte de connexion.

9. Dispositif selon l'une quelconque des revendications précédentes, **caractérisé en ce qu**'il comporte des seconds moyens de fixation (48) d'un radiateur (46) de dissipation d'énergie thermique sur au moins l'une desdites plaques d'appui (8, 10), ces seconds moyens de fixation étant indépendants et distincts des premiers moyens de fixation.

10. Dispositif selon la revendication 9, **caractérisé en ce que** les seconds moyens de fixation comportent un clip de torsion (48) apte à venir en appui sur l'une des plaques d'appui (8, 10) et sur le radiateur (46) correspondant.

11. Carte électronique, **caractérisée en ce qu**'elle comporte un dispositif de maintien par pression d'au moins deux composants électroniques (4, 6) disposés en vis-à-vis et de part et d'autre d'une même carte (2) de connexion selon l'une quelconque des revendications précédentes.

## Claims

1. Device for retaining by pressure at least two electronic components (4, 6) arranged opposite each other and on either side of the same connection board (2), said device including:
- two rigid bearing plates (8, 10) arranged on either side of the connection board (2), said plates being intended to exert a retaining force by pressure on said electronic components (4, 6) in the direction of the connection board, and
- first means for fixing these bearing plates to the connection board (2) comprising at least one clamping pin (12), and
- urging means (30, 32, 34) suitable for being mounted at the end of said at least one clamping pin, these urging means being intended to exert a thrust force on one of the bearing plates (8, 10) in the direction of the connection board,
**characterised in that**, openings being provided in the connection board, said at least one clamping pin (12) is suitable for being mounted so as to be displaceable in translation in one of said openings in order to pass through the connection board (2) and for receiving the urging means (30, 32, 34), at each of its ends, and **in that** the device includes two fixing abutments (20, 22) for limiting the translation of said at least one clamping pin (12) through the connection board, said fixing abutments each being intended to be arranged on either side of the connection board (2), spaced from one another by a distance strictly greater than the thickness of the board so as to provide, between the board and the abutments, a clearance for balancing the retaining force between the two bearing plates.

2. Device according to Claim 1, **characterised in that** said at least one clamping pin (12) comprises two bodies for receiving the fixing abutments (20, 22) spaced from one another by a distance strictly greater than the thickness of the board so as to provide, between the board and the abutments, a clearance for balancing the retaining force between the two bearing plates (8, 10).

3. Device according to any one of the preceding claims, **characterised in that** the abutments comprise a stop ring (20).

4. Device according to any one of the preceding claims, **characterised in that** the abutments comprise a washer (22).

5. Device according to any one of the preceding claims, **characterised in that** the urging means comprise thrust supports (30, 32) intended to be fixed to each end of said at least one clamping pin (12) and resilient means (34) suitable for being interposed between the thrust support (30, 32) and one of the bearing plates (8, 10) in order to act on the latter against the electronic components (4, 6).

6. Device according to Claim 5, **characterised in that** the resilient means include springs (34).

7. Device according to any one of the preceding claims, **characterised in that** it includes a plate (50, 52) for locking in rotation said at least one clamping pin (12), in which an opening is formed, intended to receive by sliding said at least one clamping pin (12), the profile of the opening, and that of said at least one clamping pin (12), being produced so as to prevent any rotational movement of said at least one clamping pin (12) with respect to the bearing plates (8, 10).

8. Device according to any one of the preceding claims, **characterised in that** the first fixing means are solely suitable for fixing said bearing plates (8, 10) to the connection board.

9. Device according to any one of the preceding claims, **characterised in that** it includes second means (48) for fixing a thermal energy dissipation radiator (46) to at least one of said bearing plates (8, 10), these second fixing means being independent of and distinct from the first fixing means.

10. Device according to Claim 9, **characterised in that** the second fixing means comprise a torsion clip (48) suitable for bearing against one of the bearing plates (8, 10) and the corresponding radiator (46).

11. Electronic card, **characterised in that** it comprises a device for retaining by pressure at least two electronic components (4, 6) arranged opposite each other and on either side of the same connection board (2) according to any one of the preceding claims.

## Patentansprüche

1. Vorrichtung zum Halten von mindestens zwei elektronischen Komponenten (4, 6) durch Druck, die gegenüberliegend und beiderseits der selben Anschluss-Karte (2) angeordnet sind, wobei die genannte Vorrichtung enthält:
- zwei starre Stützplatten (8, 10), die beiderseits der Anschluss-Karte (2) angeordnet sind, wobei die genannten Platten dazu bestimmt sind, eine Haltekraft durch Druck auf die genannten, elektronischen Komponenten (4, 6) in Richtung der Anschluss-Karte auszuüben, und
- erste Mittel zur Befestigung dieser Stützplatten an der Anschluss-Karte (2), die mindestens eine Spann-Säule (12) enthalten, und
- Druck-Mittel (30, 32, 34), dazu geeignet, am Ende der genannten, mindestens einen Spann-Säule montiert zu werden, wobei diese Druck-Mittel dazu bestimmt sind, auf eine der Stützplatten (8, 10) eine Druck-Kraft in Richtung der Anschluss-Karte auszuüben,
**dadurch gekennzeichnet, dass** Öffnungen in der Anschluss-Karte angebracht sind, wobei die genannte, mindestens eine Spann-Säule (12) dazu geeignet ist, translationsbeweglich in einer der genannten Öffnungen montiert zu werden, um die Anschluss-Karte (2) zu durchqueren und um an jedem ihrer Enden die Druck-Mittel (30, 32, 34) aufzunehmen, und dass die Vorrichtung zwei Befestigungs-Anschläge (20, 22) enthält, um die Translation der genannten, mindestens einen Spann-Säule (12) durch die Anschluss-Karte hindurch zu begrenzen, wobei die genannten Befestigungs-Anschläge dazu bestimmt sind, je beiderseits der Anschluss-Karte (2) angeordnet zu sein, voneinander mit einer Distanz beabstandet, die streng größer ist als die Dicke der Karte, so dass zwischen der Karte und den Anschlägen ein Ausgleichs-Spiel für die Haltekraft zwischen den beiden Stützplatten verbleibt.

2. Vorrichtung nach Anspruch 1, **dadurch gekennzeichnet, dass** die genannte, mindestens eine Spann-Säule (12) zwei Organe zur Aufnahme der Befestigungs-Anschläge (20, 22) enthält, die voneinander mit einer Distanz beabstandet sind, die streng größer ist als die Dicke der Karte, so dass zwischen der Karte und den Anschlägen ein Ausgleichs-Spiel für die Haltekraft zwischen den beiden Stützplatten (8, 10) verbleibt.

3. Vorrichtung nach einem beliebigen der vorstehenden Ansprüche, **dadurch gekennzeichnet, dass** die Anschläge einen Blockierring (20) enthalten.

4. Vorrichtung nach einem beliebigen der vorstehenden Ansprüche, **dadurch gekennzeichnet, dass** die Anschläge eine Rundscheibe (22) enthalten.

5. Vorrichtung nach einem beliebigen der vorstehenden Ansprüche, **dadurch gekennzeichnet, dass** die Druck-Mittel Druck-Träger (30, 32) enthalten, die dazu bestimmt sind, an jedem Ende der genannten, mindestens einen Spann-Säule (12) befestigt zu werden, und elastische Mittel (34), die dazu geeignet sind, zwischen dem Druck-Träger (30, 32) und einer der Stützplatten (8, 10) eingesetzt zu werden, um letztere gegen die elektronischen Komponenten (4, 6) zu drücken.

6. Vorrichtung nach Anspruch 5, **dadurch gekennzeichnet, dass** die elastischen Mittel Federn (34) enthalten.

7. Vorrichtung nach einem beliebigen der vorstehenden Ansprüche, **dadurch gekennzeichnet, dass** sie eine Platte (50, 52) zur Rotations-Blockierung der genannten, mindestens einen Spann-Säule (12) enthält, in der eine Öffnung geformt ist, die dazu bestimmt ist, die genannte, mindestens eine Spann-Säule (12) verschiebbar aufzunehmen, wobei das Profil der Öffnung und das der genannten, mindestens einen Spann-Säule (12) so verwirklicht ist, dass jegliche Rotations-Bewegung der genannten, mindestens einen Spann-Säule (12) gegenüber den Stützplatten (8, 12) verhindert wird.

8. Vorrichtung nach einem beliebigen der vorstehenden Ansprüche, **dadurch gekennzeichnet, dass** die ersten Befestigungs-Mittel allein dazu geeignet sind, die genannten Stützplatten (8, 10) an der Anschluss-Karte zu befestigen.

9. Vorrichtung nach einem beliebigen der vorstehenden Ansprüche, **dadurch gekennzeichnet, dass** sie auf mindestens einer der genannten Stützplatten (8, 10) zweite Befestigungs-Mittel (48) zur Befestigung eines Kühlers (46) zur Wärmeabfuhr enthält, wobei diese zweiten Befestigungs-Mittel unabhängig und getrennt von den ersten Befestigungs-Mitteln sind.

10. Vorrichtung nach Anspruch 9, **dadurch gekennzeichnet, dass** die zweiten Befestigungs-Mittel eine Torsions-Klammer (48) enthalten, die dazu geeignet ist, sich an eine der Stützplatten (8, 10) und auf den entsprechenden Kühler (46) zu stützen.

11. Elektronische Karte, **dadurch gekennzeichnet, dass** sie eine Vorrichtung zum Halten von mindestens zwei elektronischen Komponenten (4, 6), die gegenüberliegend und beiderseits einer selben Anschluss-Karte (2) angeordnet sind, durch Druck nach einem beliebigen der vorstehenden Ansprüche enthält.
